# EUROPÄISCHE PATENTSCHRIFT

(11) **EP 0 705 654 B1**
(45) Veröffentlichungstag und Bekanntmachung des Hinweises auf die Patenterteilung: **07.10.1998**
(21) Anmeldenummer: 95112993.1
(22) Anmeldetag: 18.08.1995
(51) Int. Cl.: B23C 3/28, G06K 19/077

(54) **Werkzeugmaschine**
Machine tool
Machine-outil

(30) Priorität: 16.09.1994 DE 4433076
(43) Veröffentlichungstag der Anmeldung: 10.04.1996
(73) Patentinhaber: MELZER MASCHINENBAU GmbH, D-58332 Schwelm (DE)
(72) Erfinder: Melzer, Rainer, D-58332 Schwelm (DE); Melzer, Roland, D-58332 Schwelm (DE)
(74) Vertreter: Sparing - Röhl - Henseler Patentanwälte

(56) Entgegenhaltungen:
- EP-A- 0 589 771
- US-A- 4 382 728

## Beschreibung

Die Erfindung betrifft eine Werkzeugmaschine zur spanabhebenden Bearbeitung von Werkstücken. Sie wurde insbesondere konzipiert für das Einfräsen von genormten Ausnehmungen in Chipkarten, in welche elektronische Chips einzufügen sind. Solche Ausnehmungen müssen hohe Genauigkeit aufweisen, und gleichwohl soll die Maschine mit hohen Durchsätzen arbeiten können, um eine Anpassung an die übrigen Stationen einer Chipkartenstraße zu ermöglichen. Es ist aber anzumerken, daß die Maschine gemäß der Erfindung keineswegs auf diesen Anwendungsfall beschränkt ist.

Aufgabe der Erfindung ist es, eine solche Werkzeugmaschine zu schaffen, bei der die beim Zustellen zu beschleunigenden und abzubremsenden Massen möglichst niedrig sind und eine genau definierte Ruheposition des Werkzeugs spielfrei vorgegeben ist.

Die erfindungsgemäße Lösung ist im Patentanspruch 1 definiert; die von ihm direkt oder indirekt abhängenden Ansprüche 2 bis 13 definieren vorteilhafte Weiterbildungen dieses Konzepts, während die Ansprüche 14 bis 16 sich auf den Betrieb der Maschine beziehen.

Die beigefügten Zeichnungen stellen eine bevorzugte Ausführungsform der Erfindung dar.
Fig. 1 ist eine perspektivische Gesamtansicht,

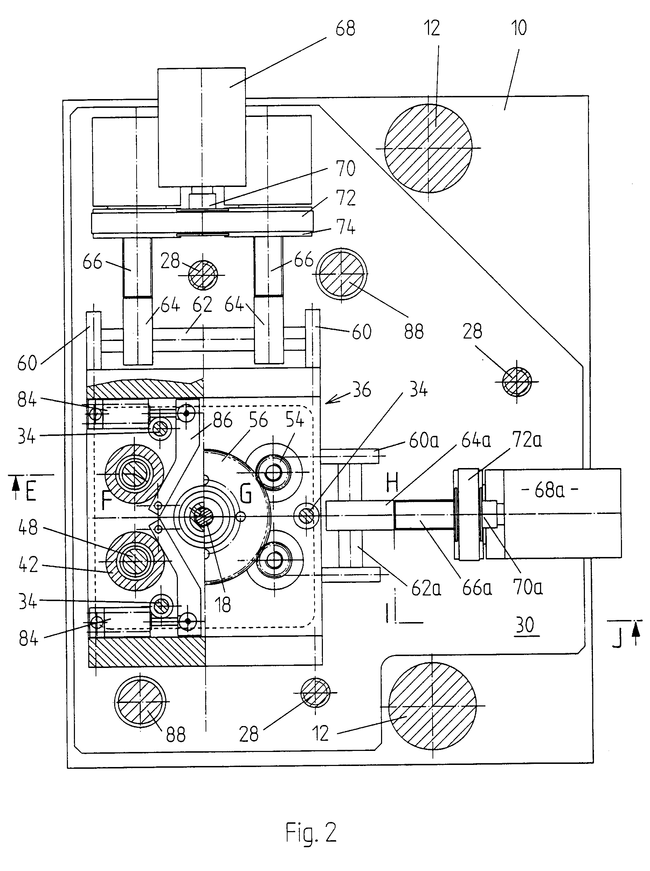

Fig. 2 ist ein Schnitt nach Linie A-B-C-D der Fig. 3, und
Fig. 3 ist ein Schnitt nach Linie E-F-G-J der Fig. 2.

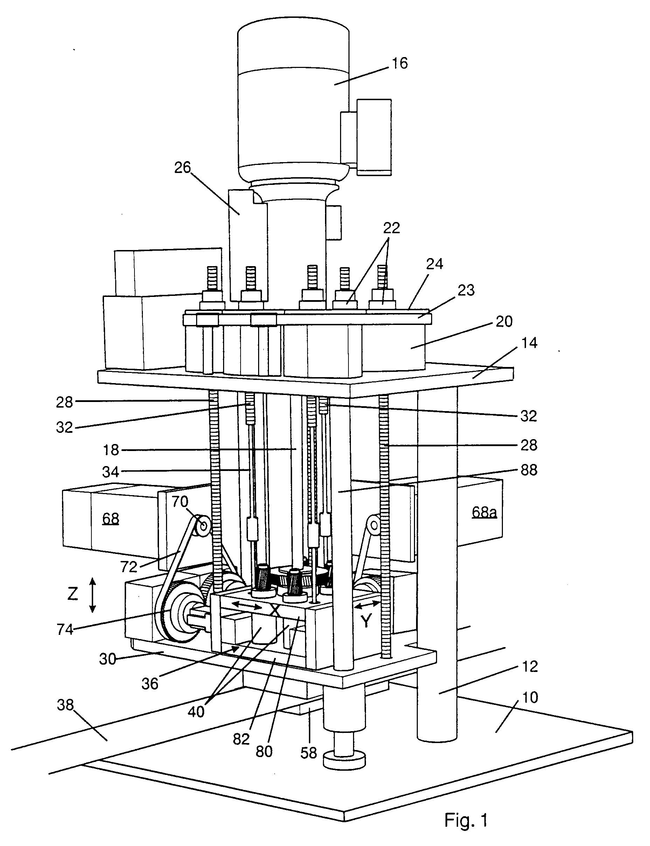

Man erkennt in Fig. 1 einen Sockel 10, Säulen 12 (nur eine in Fig. 1 dargestellt) und eine Ständerplatte 14, die von den Säulen getragen ist; die Komponenten 10, 12 und 14 bilden ein ortsfestes Gestell. Auf der Ständerplatte 14 ist ein Spindelantriebsmotor 16 montiert, dessen Abtriebswelle 18 in noch zu beschreibender Weise mit der Arbeitsspindel gekuppelt ist. Ferner trägt die Ständerplatte 14 sechs Lagerblöcke 20, in welchen sechs Spindelmuttern 22 axial abgestützt drehbar gelagert sind. Ein Zahnriemen (nicht dargestellt) steht im Eingriff mit sechs, jeweils einer der Spindelmuttern zugeordneten Ritzeln 24 und einem Abtriebszahnrad eines Z-Motors 26 derart, daß bei Erregung des Motors 26 alle Ritzel gleichsinnig um gleiche Winkel umlaufen.

Mit jeder Spindelmutter ist eine gegen Drehung gesicherte Gewindespindel im Eingriff. Drei dieser Gewindespindeln, mit 28 bezeichnet, tragen eine Basisplatte 30. Die drei anderen, mit 32 bezeichnet, sind mit je einem Biegestab 34 verbunden, dessen anderes Ende in einem Spindelkopf 36 festgelegt ist.

Diese Biegestäbe haben zunächst die Aufgabe, das Gewicht des Spindelkopfs 36 aufzunehmen. Darüber hinaus liefern sie, bei Auslenkung in X- oder Y-Richtung (die Richtungen X, Y und Z sind in Fig. 1 durch entsprechende Pfeile angedeutet), eine Rückstellkraft, die Beschleunigungen und Verzögerungen des Spindelkopfes bei der motorischen Auslenkung unterstützt. Drei Stäbe sind vorgesehen, um mit drei Punkten eine Ebene des Spindelkopfes zu definieren; seine Drehsicherung erfolgt auf noch zu beschreibende Weise.

Der Spindelkopf 36 trägt mindestens eine Arbeitsspindel. Im Ausführungsbeispiel sind vier solcher Spindeln vorgesehen, die untereinander gleich ausgebildet sind und deshalb alle mit demselben Bezugszeichen 40 versehen sind. Es ist aber anzumerken, daß auch weniger als vier oder, mit größerer Wahrscheinlichkeit, mehr als vier, beispielsweise zwanzig oder mehr, solcher Arbeitsspindeln vorgesehen werden können, deren Antriebe untereinander über Getriebe gekuppelt sind.

Jede Arbeitsspindel umfaßt eine Lagerhülse 42, in der mittels Wälzlagern 44, 46 die Spindelwelle 48 axial und radial abgestützt ist. Am unteren Ende der Spindelwelle ist ein handelsüblicher Spannkopf 50 für das Einspannen des Werkzeugs 52 (hier z.B. ein Einzahnfräser) angeordnet. Am oberen Spindelwellenende ist ein Ritzel 54 drehfest angebracht, und die Ritzel 54 aller vier Spindeln kämmen mit einem allen Spindeln gemeinsam zugeordneten Antriebszahnrad 56. Die Materialpaarung der Ritzel einerseits, des Zahnrads andererseits ist so gewählt, daß möglichst schmierungsfrei gearbeitet werden kann; so könnten Stahlritzel mit einem Preßstoffzahnrad gepaart werden. Dies gilt für den hier vorgesehenen Anwendungsfall, bei dem die zu übertragenden Drehmomente gering sind und dafür die Gefahr der Verschmutzung der Werkstücke unbedingt zu vermeiden ist.

Das Zahnrad 56 wird von dem Spindelantriebsmotor 16 über dessen Abtriebswelle 18 angetrieben. Diese Welle ist generell als "Biegewelle" bezeichnet, weil ihr unteres mit dem Antriebszahnrad 56 gekuppeltes Ende den X- und Y-Zustellungen folgen muß, während ihr oberes Ende insoweit ortsfest ist. Der Begriff "Biegewelle" umfaßt nicht nur solche Konstruktionen, die tatsächlich einer Biegebeanspruchung unterworfen werden, sondern alle bekannten Bauarten von Wellen, bei denen im Betrieb die Wellenenden eine Fehlausfluchtung verkraften, also etwa Gleichlaufgelenkwellen und dergleichen. Die Auswahl hängt auch hier vom vorgesehenen Anwendungsfall ab, insbesondere den zu übertragenden Momenten.

Der Spindelkopf 36 trägt ein erstes Paar von Wangen 60, zwischen denen sich ein erster zylindrischer Führungsstab 62 parallel zur Y-Achse erstreckt. Auf ihm sitzen Koppelstücke 64, die wälzgelagert längs des Stabes verschieblich sind und ihrerseits in X-Richtung durch das Zusammenwirken eines Schneckenrades (nicht dargestellt) mit einer Schneckenwelle 66, vorzugsweise einer Kugelspindel, verlagerbar sind. Die beiden Schneckenwellen 66 werden von einem X-Motor 68 über dessen Abtriebsritzel 70, Zahnriemen 72 und Zahnräder 74 gleichsinnig um gleiche Winkel verdreht. Diese Anordnung bildet zugleich die Geradführung für den Spindelkopf 36 und dessen Drehsicherung.

In ähnlicher Weise erfolgt die Zustellung in Y-Richtung, wobei wiederum ein Paar von Wangen 60a, Führungsstab 62a, ein Koppelstück 64a (hier wird nur eines benötigt) mit zugeordneter Schneckenwelle 66a, Y-Motor 68a, Ritzel 70a, Zahnriemen 72a und Zahnrad 74a vorgesehen sind.

Der X-, Y- und Z-Motor können CNC-gesteuert sein. Dies begrenzt jedoch die Arbeitsgeschwindigkeit. Es ist selbstverständlich möglich, wenn immer dieselbe Arbeit auszuführen ist wie im Falle des Fräsens der Chipaufnahmen in Chipkarten, die Steuerung durch Verwendung von Führungskurven vorzugsweise in Verbindung mit Endschaltern zu vereinfachen.

Der Spindelkopf 36 besteht aus einer Oberplatte 80 und einer Unterplatte 82. Beide Platten 80, 82 weisen fluchtende Durchbrüche zur Aufnahme jeweils einer der Arbeitsspindeln 40 auf. Die Lagerhülsen 42 der Arbeitsspindeln sitzen gleitverschieblich in den Durchbrüchen, so daß sie höheneinstellbar sind; man erkennt, daß die Axialabmessung der Ritzel 54 größer ist als die des sie antreibenden Zahnrads 56, womit das Maß der Höhenverstellung der Arbeitsspindeln vorgegeben ist. Im Betrieb müssen die Lagerhülsen 42 aber natürlich axialfest sein. Hierfür ist eine Klemmvorrichtung vorgesehen, bestehend aus einem Arbeitszylinder 84 (z.B. Pneumatikzylinder), dessen Kolbenstangen mit einer Klemmbacke 86 gekuppelt ist, welche bei Betätigung des Zylinders 84 jeweils eine der Arbeitsspindeln gegen die Ober- und Unterplatte 80 bzw. 82 des Spindelkopfes 36 preßt.

Wenn beispielsweise ein Werkzeug oder eine Arbeitsspindel auszuwechseln ist, kann die Basisplatte 30 mittels der Gewindespindeln 28 längs Führungssäulen 88 angehoben werden; zugleich bewegt sich auch der Spindelkopf 36 mittels der Gewindespindeln 32 nach oben. Die Arbeitsspindeln können dann gelöst und nach unten entnommen werden, nachdem die noch zu beschreibenden Platten 90 und 92 entfernt worden sind. Diese Konzeption ermöglicht ein sehr einfaches Vorgehen beim Einrichten der Maschine. Wenn, wie hier, vier Ausnehmungen gleichzeitig in vier Chipkarten einzufräsen sind, werden zunächst die vier Einzahnfräser grob axial im Spannkopf 50 ihrer Arbeitsspindel positioniert. Der Spindelkopf wird dann bei gelösten Arbeitsspindeln auf das Chipkartenmaterial abgesenkt, bis alle vier Fräser auf dieser Bezugsebene aufsitzen. In dieser Lage werden die Arbeitsspindeln festgeklemmt, und die Z-Zustellung erfolgt mit dieser Bezugsebene als Referenz.

Es versteht sich, daß bei Auslenkungen in X- und Y-Richtung wegen der Biegestäbe 34 auch eine Verlagerung in Z-Richtung (nach oben) erfolgt. Bei der Bearbeitung von Chipkarten ist dies nicht nachteilig, weil der Kleber zum Befestigen der Chips in den Karten dann einwärts fließt. In anderen Fällen müßte ein solcher Z-Fehler durch entsprechende entgegengerichtete Zustellung in Richtung -Z korrigiert werden, wobei das Maß rechnerisch oder experimentell bestimmt werden kann.

Wie oben bereits angedeutet, ist es im vorliegenden Anwendungsfall von besonderer Bedeutung, daß weder die Maschine selbst noch die Werkstücke verschmutzen. Insbesondere muß sorgfältig darauf geachtet werden, daß die Späne des abgetragenen Materials nicht zusammen mit den Werkstücken aus der Maschine heraustransportiert werden. Hierfür ist eine besonders gestaltete Absaugvorrichtung vorgesehen.

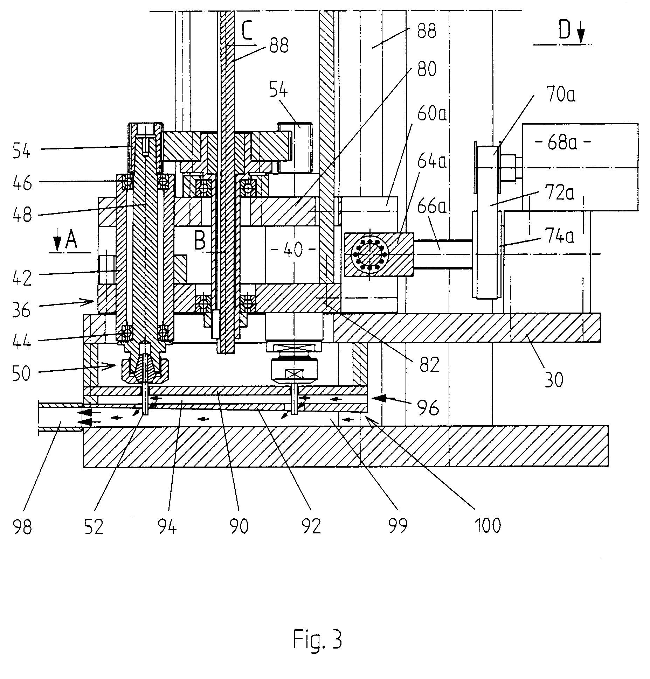

Die Schäfte der Werkzeuge 52 erstrecken sich durch enge Durchbrüche einer Schutzplatte 90 und durch relativ viel größere Durchbrüche einer unter der Schutzplatte 90 angeordneten Leitplatte 92. Die zwischen beiden Platten gebildete Kammer 94 ist am einen Ende (links in Fig. 3) geschlossen; in das gegenüberliegende Ende wird von einem Gebläse (durch Pfeil 96 angedeutet) Druckluft eingeblasen, die durch die Durchbrüche der Leitplatte strömt und dabei die Werkzeuge wie auch die Werkstücke kühlt. Der Raum 99 unter der Leitplatte ist mit einer der Gebläsemündung gegenüberliegenden Mündung 98 einer Unterdruckquelle verbunden. Es ist erkennbar, daß die Leitplatte 92 in Richtung dieser Mündung 98 allmählich dünner wird, der Einlaß 100 in den Raum 99 also einen geringeren Einströmquerschnitt aufweist als die Mündung. Dies ergibt einen Druckgradienten vom Einlaß 100 zur Mündung 98, so daß nur eine Strömung in Richtung der eingezeichneten Pfeile möglich ist und somit alle Späne abgeführt werden.

Der Vollständigkeit halber sei noch auf die in Fig. 1 dargestellte Chipkartenbahn 38 hingewiesen, die von einem im Arbeitsbereich der Maschine vorgesehenen Saugkissen 58 in Form einer gekühlten Platte festgehalten ist und mittels nicht dargestellter Registrierstifte positioniert wird.

## Patentansprüche

1. Werkzeugmaschine, umfassend:
- eine Arbeitsspindel (40), die in einem in drei zueinander senkrechten Richtungen X, Y, Z verlagerbaren Spindelkopf (36) drehbar gelagert ist, deren Achse sich in Richtung Z erstreckt und die einen Spannkopf (50) zur Aufnahme eines spanabhebenden Werkzeugs (52) trägt,
- ein ortsfestes Gestell (10, 12, 14), das in Richtung Z zu dem Spindelkopf versetzt einen Spindelantriebsmotor (16) trägt,
- drei biegsame Stäbe (34), mittels denen der Spindelkopf an dem Gestell aufgehangen und in Z-Richtung verlagerbar ist,
- eine Basisplatte (30), relativ zu der der Spindelkopf in X- und Y-Richtung geführt ist, die ebenfalls an dem Gestell aufgehangen ist und gemeinsam mit dem Spindelkopf in Z-Richtung verlagerbar ist.

2. Maschine nach Anspruch 1, bei der die Basisplatte X-Y-Zustellantriebsmotoren (68, 68a) für die Verlagerung des Spindelkopfes in X- und Y-Richtung aufweist.

3. Maschine nach Anspruch 1 oder 2, bei der die Welle des Spindelantriebsmotors über eine biegsame Welle (18) mit der Arbeitsspindelwelle (48) gekuppelt ist.

4. Maschine nach einem der Ansprüche 1 bis 3, bei der eine Mehrzahl von Arbeitsspindeln in dem Spindelkopf angeordnet ist, denen ein gemeinsamer Spindelantriebsmotor zugeordnet ist.

5. Maschine nach einem der Ansprüche 1 bis 4, bei der der Spindelkopf und die Basisplatte mittels Gewindespindeln (28, 32) in Z-Richtung verlagerbar sind.

6. Maschine nach Anspruch 5, bei der die biegsamen Stäbe selbst Gewindespindeln aufweisen.

7. Maschine nach Anspruch 5 oder 6 mit einem gemeinsamen Z-Zustellmotor (26) für alle Gewindespindeln.

8. Maschine nach einem der Ansprüche 5 bis 7 mit drei Gewindespindeln, mittels denen die Basisplatte am Gestell aufgehangen ist.

9. Maschine nach einem der vorangehenden Ansprüche, bei der jede Arbeitsspindel eine Hülse (42) umfaßt, in der die Arbeitsspindelwelle gelagert ist und die in dem Spindelkopf nach Lösen einer Klemmeinrichtung (84, 86) in Z-Richtung verlagerbar ist.

10. Maschine nach Anspruch 1, bei der der Spindelkopf längs Steuerkulissen geführt ist.

11. Maschine nach Anspruch 10, bei der die Umsteuerung von Verlagerung in X-Richtung zu Verlagerung in Y-Richtung und umgekehrt mittels Endschaltern erfolgt.

12. Maschine nach einem der vorangehenden Ansprüche mit einer Spanabsaugevorrichtung.

13. Maschine nach Anspruch 12, bei der die Spanabsaugevorrichtung umfaßt:
- eine Schutzplatte (90) unterhalb der Arbeitsspindel mit einem relativ engen Durchbruch für einen Werkzeugschaft,
- eine Leitplatte (92) unterhalb der Schutzplatte mit einem relativ weiten Durchbruch für den Werkzeugschaft,
- ein Gebläse (96) zum Einblasen von Kühlluft für das Werkzeug in den Spalt zwischen Schutzplatte und Leitplatte,
- eine unterhalb der Leitplatte und gegenüber der Gebläsemündung angeordnete, mit einer Unterdruckquelle verbundene Absaugöffnung (100).

14. Anwendung der Maschine nach einem der vorangehenden Ansprüche für das Fräsen von Ausnehmungen zur Aufnahme von Chips in Chipkarten.

15. Verfahren zum Einrichten der Maschine nach Anspruch 9 für die Anwendung nach Anspruch 14 mit den Schritten:
- der Spindelkopf wird angehoben,
- die Klemmeinrichtungen aller Spindeln werden gelöst,
- der Spindelkopf wird abgesenkt, bis alle Fräswerkzeuge auf den Kartenrohlingen aufsitzen, so daß deren Oberflächen die Bezugsebenen für die Frästiefensteuerung darstellen,
- alle Spindelhülsen werden am Spindelkopf festgeklemmt.

16. Verfahren zum spanabhebenden Bearbeiten von Werkstücken mittels der Maschine nach einem der Ansprüche 1 bis 13, bei dem eine Verlagerung in Z-Richtung zur Kompensation von Z-Fehlern infolge Verlagerung in X-und Y-Richtung vorgenommen wird.

## Claims

1. Machine tool, comprising:
- an operating spindle (40), which is rotatably mounted in a spindle head (36) displaceable in three directions X, Y, Z perpendicular to one another, and the axis of which extends in the Z direction and which carries a clamping chuck (50) to receive a material-removing tool (52),
- a stationary frame (10, 12, 14) which, offset in the Z direction with respect to the spindle head, carries a spindle drive motor (16),
- three flexible rods (34), by means of which the spindle head is suspended on the frame and is displaceable in the Z direction,
- a base plate (30), relative to which the spindle head is guided in the X and Y direction, which is also suspended on the frame and is displaceable together with the spindle head in the Z direction.

2. Machine according to Claim 1, wherein the base plate has X-Y-positioning motors (68, 68a) for the displacement of the spindle head in the X and Y direction.

3. Machine according to Claim 1 or 2, wherein the shaft of the spindle drive motor is coupled by way of a flexible shaft (18) to the operating spindle shaft (48).

4. Machine according to one of Claims 1 to 3, wherein there is arranged in the spindle head a plurality of operating spindles with which a common spindle drive motor is associated.

5. Machine according to one of Claims 1 to 4, wherein the spindle head and the base plate are displaceable in the Z direction by means of screw-threaded spindles (28, 32).

6. Machine according to Claim 5, wherein the flexible rods themselves have screw-threaded spindles.

7. Machine according to Claim 5 or 6 with a common Z-positioning motor (26) for all the screw-threaded spindles.

8. Machine according to one of Claims 5 to 7 with three screw-threaded spindles, by means of which the base plate is suspended on the frame.

9. Machine according to one of the preceding claims, wherein each operating spindle comprises a sleeve (42) in which the operating spindle shaft is mounted and which is displaceable in the Z direction in the spindle head, after a clamping means (84, 86) has been released.

10. Machine according to Claim 1, wherein the spindle head is guided along control slides.

11. Machine according to Claim 10, wherein the switch-over from displacement in the X direction to displacement in the Y direction and vice versa is effected by means of end switches.

12. Machine according to one of the preceding claims with a chippings suction extractor device.

13. Machine according to Claim 12, wherein the chippings suction extractor device comprises:
- a guard plate (90) beneath the operating spindle with a relatively narrow aperture for a tool shank,
- a guide plate (92) beneath the guard plate with a relatively wide aperture for the tool shank,
- a fan (96) for blowing in cooling air for the tool into the gap between guard plate and guide plate,
- a suction opening (100) connected to a low pressure source and arranged beneath the guide plate and opposite the mouth of the fan.

14. The use of the machine according to one of the preceding claims for the milling of recesses to receive chips in chip cards.

15. Method for setting-up the machine according to Claim 9 for the use according to Claim 14 with the following steps:
- the spindle head is raised,
- the clamping means of all the spindles are released,
- the spindle head is lowered until all the milling tools sit on the card blanks, so that their surfaces form the reference planes for the milling depth control,
- all spindle sleeves are clamped firmly on the spindle head.

16. Method for removing material from workpieces by means of the machine according to one of Claims 1 to 13, wherein displacement in the Z direction is undertaken to compensate for Z-errors as a result of displacement in the X and Y direction.

## Revendications

1. Machine outil, comprenant :
- une broche de travail (40) qui est montée à rotation dans une tête de broche (36) pouvant être déplacée selon trois directions perpendiculaires X, Y, Z dont l'axe s'étend selon la direction Z et qui porte une tête de serrage (50) pour recevoir un outil (52) d'enlèvement de copeaux,
- un bâti fixe (10, 12, 14) qui porte un moteur (16) d'entraînement de la broche décalé dans la direction Z par rapport à la tête de broche,
- trois barres flexibles (34), par lesquelles la tête de broche est suspendue au bâti et peut être déplacée selon la direction Z,
- une plaque de base (30) par rapport à laquelle la tête de broche est guidée selon les directions X et Y, ladite plaque étant aussi suspendue au bâti et pouvant être déplacée en bloc avec la tête de broche selon la direction Z.

2. Machine selon la revendication 1 dans laquelle la plaque de base présente des moteurs d'avance X-Y pour le déplacement de la tête de broche selon les directions X et Y.

3. Machine selon la revendication 1 ou 2 dans laquelle l'arbre du moteur d'entraînement est relié à l'arbre de la broche de travail (48) par un arbre flexible (18).

4. Machine selon l'une des revendications 1 à 3 dans laquelle une pluralité de broches de travail sont montées dans la tête de broche, auxquelles est associé un moteur d'entraînement de broche commun.

5. Machine selon l'une des revendications 1 à 4 dans laquelle la tête de broche et la plaque de base peuvent être déplacées selon la direction Z au moyen de tiges filetées (28, 32).

6. Machine selon la revendication 5 dans laquelle les barres flexibles comprennent elles-mêmes des tiges filetées.

7. Machine selon la revendication 5 ou 6 comprenant un moteur d'avance (26) selon Z commun pour toutes les tiges filetées.

8. Machine selon l'une quelconque des revendications 5 à 7 comprenant trois tiges filetées par lesquelles la plaque de base est suspendue au bâti.

9. Machine selon l'une quelconque des revendications précédente, dans laquelle chaque broche de travail comprend une douille (42) dans laquelle est monté l'arbre de la broche de travail et qui peut être déplacée selon la direction Z après desserrage d'un dispositif de serrage (84, 86).

10. Machine selon la revendication 1 dans laquelle la tête de broche est guidée le long de coulisses de commande.

11. Machine selon la revendication 10 dans laquelle la commutation du déplacement selon la direction X vers le déplacement selon la direction Y et inversement s'effectue à l'aide d'interrupteurs de fin de course.

12. Machine selon l'une quelconque des revendications précédentes comprenant un dispositif d'aspiration de copeaux.

13. Machine selon la revendication 12 dans laquelle le dispositif d'aspiration de copeaux comprend :
- un écran de protection (90) disposé sous la broche de travail et muni d'une ouverture relativement étroite pour une tige d'outil,
- une plaque de guidage (92) disposée sous l'écran de protection et munie d'une ouverture relativement étroite pour la tige d'outil,
- une buse (96) pour souffler de l'air de refroidissement pour l'outil dans l'espace situé entre l'écran de protection et la plaque de guidage,
- une ouverture d'aspiration (100) disposée sous la plaque de guidage et en face de l'orifice de soufflage et reliée à une source de vide,.

14. Utilisation de la machine selon l'une des revendications précédentes pour le fraisage d'évidements destinés à recevoir des puces dans des cartes à puce.

15. Procédé de réglage de la machine selon la revendication 9 pour l'utilisation selon la revendication 14 comportant les étapes de :
- lever la tête de broche,
- desserrer les dispositifs de serrage de toutes les broches
- descendre la tête de broche jusqu'à ce que toutes les fraises reposant sur les ébauches des cartes de sorte que les surfaces de celles-ci forment les plans de référence pour la commande en profondeur des fraises,
- serrer toutes les douilles de broche sur la tête de broche.

16. Procédé d'usinage de pièces par enlèvement de copeaux au moyen de la machine selon l'une des revendications 1 à 13, dans lequel on procède à un déplacement selon la direction Z pour la compensation d'erreurs selon Z suite à un déplacement selon la direction X et la direction Y.
